(19) Europäisches Patentamt
European Patent Office
Office européen des brevets

(11) **EP 4 769 942 A1**

(12) **EUROPEAN PATENT APPLICATION**

(43) Date of publication:
**01.07.2026 Bulletin 2026/27**

(21) Application number: **25227540.9**

(22) Date of filing: **30.12.2025**

(51) International Patent Classification (IPC):
*H03F 1/32* (2006.01)　　　　*H03F 3/45* (2006.01)
*H03F 3/21* (2006.01)

(52) Cooperative Patent Classification (CPC):
**H03F 3/45098; H03F 1/3211; H03F 3/211;**
**H03F 3/45197; H03F 3/45295; H03F 3/45475;**
**H03F 3/4595; H03F 3/45982;** H03F 2200/168;
H03F 2200/429; H03F 2203/45114;
H03F 2203/45511; H03F 2203/45594

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **30.12.2024 US 202419005166**

(71) Applicant: **Harman International Industries,**
**Incorporated**
**Stamford, CT 06901 (US)**

(72) Inventor: **DANYUK, Dimitri**
**Northridge, CA, 91329 (US)**

(74) Representative: **Rummler, Felix**
**Maucher Jenkins**
**Liebigstraße 39**
**80538 München (DE)**

(54) **FEEDBACK AMPLIFIER INPUT STAGE CIRCUIT**

(57)　In at least one embodiment, a feedback amplifier is provided. The amplifier includes an input stage circuit (206) and a collector element (208). The input stage circuit (206) is configured to receive at least one input feedback signal having wide band frequency components that include high frequency components and low frequency components. The input stage circuit (206) includes a first gain stage (220), a filter, and a second gain stage (222). The first gain stage (220) amplifies the at least one input feedback signal to generate at least one amplified output signal. The filter filters the wide band frequency components on the at least one input feedback signal to generate at least one filtered feedback signal having a first low frequency component. The second gain stage (222) amplifies the at least one filtered feedback signal having the first low frequency component and to provide at least one gain output signal.

Fig-5

**Description**

TECHNICAL FIELD

Aspects disclosed herein generally relate to a feedback amplifier input stage circuit. These aspects and others will be discussed in more detail herein.

BACKGROUND

A common emitter circuit (or "common emitter amplifier") is a widely used linear amplifier. An input signal is generally applied to a base terminal of the common emitter circuit and an output signal may be received via a load resistor. A common collector amplifier utilizes a single transistor in which a collector terminal is common to both input and output circuits. As an output signal is taken across an emitter resistor, a collector resistor is not utilized such that a collector terminal is connected directly to a supply rail. This type of amplifier is known as a voltage follower as the output signal follows the input signal.

If the common emitter amplifier is combined with the common collector amplifier and outputs from both the collector and emitter terminals are provided at the same time, a transistor circuit may be generated which produces two output signals that are inverted with respect to one another. In various instances, an overload at an input stage of the transistor circuit may cause unwanted distortion. Therefore, it may be desirable to remove an overload condition at the input stage.

SUMMARY

In at least one embodiment, a feedback amplifier is provided. The amplifier includes an input stage circuit and a collector element. The input stage circuit is configured to receive at least one input feedback signal having wide band frequency components that include high frequency components and low frequency components. The input stage circuit includes a first gain stage, a filter, and a second gain stage. The first gain stage amplifies the at least one input feedback signal to generate at least one amplified output signal. The filter filters the wide band frequency components on the at least one input feedback signal to generate at least one filtered feedback signal having a first low frequency component. The second gain stage amplifies the at least one filtered feedback signal having the first low frequency component and to provide at least one gain output signal. The collector element receives the at least one amplified output signal and the at least one output gain signal having the amplified filtered first low frequency component and provides at least one output signal to at least one output stage.

In at least one embodiment, a feedback amplifier is provided. The amplifier includes an input stage circuit and a collector element. The input stage circuit is configured to receive at least one input feedback signal having wide band frequency components that include high frequency components and low frequency components. The input stage circuit includes a first gain stage, a filter, and a second gain stage. The first gain stage amplifies the at least one input feedback signal to generate at least one amplified output signal. The filter filters the wide band frequency components on the at least one input feedback signal to generate at least one filtered feedback signal having a first low frequency component. The second gain stage amplifies the at least one filtered feedback signal having the first low frequency component and to provide at least one gain output signal. The at least one output stage receives the at least one amplified output signal and amplifies the at least one amplified output signal to generate at least one final output signal.

In at least one embodiment, a feedback amplifier is provided. The amplifier includes an input stage circuit and a collector element. The input stage circuit is configured to receive at least one input feedback signal having wide band frequency components that include high frequency components and low frequency components. The input stage circuit includes a first gain stage, a filter, and a second gain stage. The first gain stage amplifies the at least one input feedback signal to generate at least one amplified output signal. The filter filters the wide band frequency components on the at least one input feedback signal to generate at least one filtered feedback signal having a first low frequency component. The second gain stage amplifies the at least one filtered feedback signal having the first low frequency component and to provide at least one gain output signal. The collector element receives the at least one amplified output signal and the at least one output gain signal having the amplified filtered first low frequency component and provides at least one output signal to at least one output stage.

In at least one embodiment, a feedback amplifier is provided. The amplifier includes an input stage circuit and a collector element. The input stage circuit is configured to receive at least one input feedback signal having wide band frequency components that include high frequency components and low frequency components. The input stage circuit a first gain stage, a filter, and a second gain stage. The first gain stage amplifies the at least one input feedback signal to generate at least one amplified output signal. The filter filters the wide band frequency components on the at least one input feedback signal to generate at least one filtered feedback signal having a first low frequency component. The second gain stage amplifies the at least one filtered feedback signal having the first low frequency component and to provide at least one gain output signal. The collector element receives the at least one amplified output signal to the at least one output gain signal having the amplified filtered first low frequency component and provide at least one output signal to at least one output stage.

BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:

FIGURE 1 illustrates one example of an amplifier input stage having a transconductance reduction;

FIGURE 2 illustrates another example of an amplifier input stage including an impedance network having a frequency dependent transconductance reduction;

FIGURE 3 illustrates one example of an error signal of an input stage;

FIGURE 4 illustrates one example of an amplifier input stage with different devices;

FIGURE 5 depicts a feedback amplifier in accordance with one embodiment of the present application; and

FIGURE 6 depicts a dual differential amplifier having the input stage in accordance with one embodiment of the present application.

DETAILED DESCRIPTION

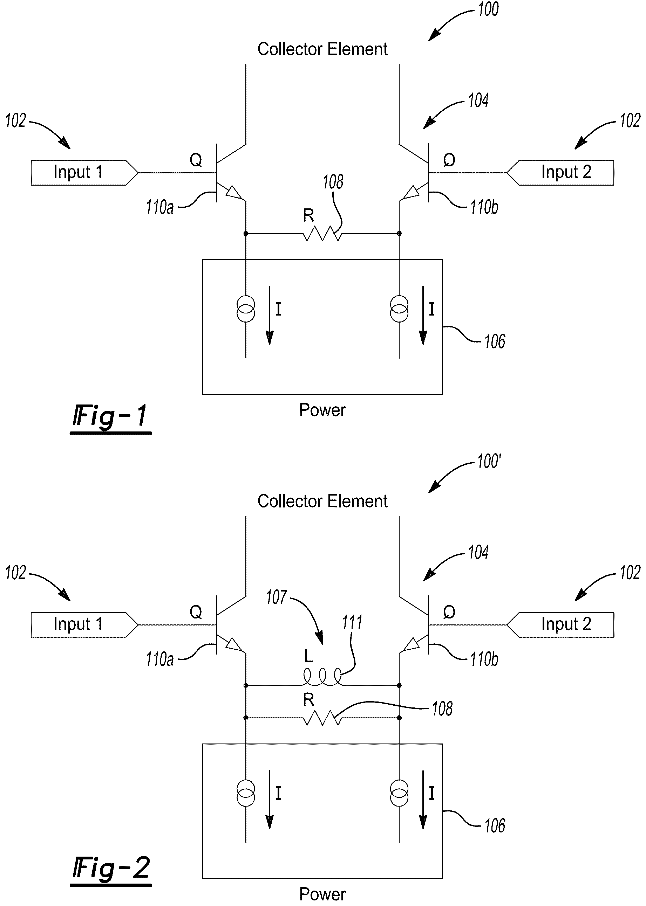

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.
Aspects disclosed herein generally relate to a feedback amplifier input stage circuit and, more particularly, to an input stage circuit that extends an operating range for input signals received at the input stage circuit. With prior implementations, specific distortion may appear as a result of an overload of the amplifier input stage that precedes the rest of the remaining network in the feedback amplifier which determines an amplifier main pole in an amplifier transfer function. One characteristic feature of an overload at the input stage is the anomalously rapid increase in nonlinear distortion with a frequency of an input signal. The disclosed feedback amplifier (see below) may retain a high loop gain (e.g., keep static distortion low) and eliminate dynamic distortion by adjustment of an acceptable range of the input signal with the spectrum of the error signal.
Additionally or alternatively, the disclosed feedback amplifier includes an input stage circuit having a differential pair of matched junction field effect transistors coupled in a common-source configuration and a differential pair of matched bipolar transistors that coupled in a common emitter configuration. Bases of a bipolar differential stage are connected to sources of the junction field effect transistors with reactive networks. The third reactive network is connected between bases of the bipolar differential stage. Each reactive network is arranged in a manner whereby at high frequencies, the bipolar stage has a relatively low gain and the input stage circuit has wide operating range for the input signals. These aspects and others will be discussed in more detail below.
Reference will be made the examples shown in FIGUREs 1 and 2. For example, FIGURE 1 illustrates one example an amplifier 100 including an input stage 102, a differential gain stage 104, a plurality of current sources 106, and an emitter circuit (or resistor 108) (or transconductance reduction section in a form of the resistor 108). FIGURE 2 illustrates the amplifier 100' including the input stage, 102, the differential gain stage 104, a plurality of current sources 106, an emitter circuit (or resistor 108) (or transconductance reduction section in a form of the resistor 108) and an inductor 111. The differential gain stage 104 includes a differential pair of matched transistors 110a, 110b in a common-emitter configuration. Base terminals of the transistors 110a, 110b serve, respectively, as non-inverting and inverting input amplifier terminals. The amplifier 100 produces an output signal, that is proportional to an output current of the transistors 110a, 110b to the difference between signals being applied to a pair of an input terminals (e.g., Input 1 and Input 2).
The overload of the input stage 102 causes an output current limiting. If the input stage 102 loads by a network (not shown), which determines amplifier main pole in a transfer function, then current limiting causes specific distortion. In general, one feature of note is that this distortion experiences an anomalously rapid increase of the nonlinear distortion with a rise of the frequency of the input signal provided to the input stage 102.

The gain of a feedback amplifier 100 may be written as:

$$W(s) = \frac{1}{\beta(s)} \frac{1}{1 + \frac{1}{\beta(s)G(s)}}$$

where $\beta(s)$ is a feedback ratio of the feedback network, s - complex frequency); $G(s)$ - is an amplifier gain without feedback. The greater will be loop gain $\beta(s)G(s)$, thus, the more precisely $W(s)$ approaches a desired value $\frac{1}{\beta(s)}$. The input signal of the first stage $U_{err}$:

$$U_{err}(s) = \frac{U_{out}(s)}{G(s)} = \frac{U_{in}(s)W(s)}{G(s)} = \frac{U_{in}(s)}{1 + \beta(s)G(s)}$$

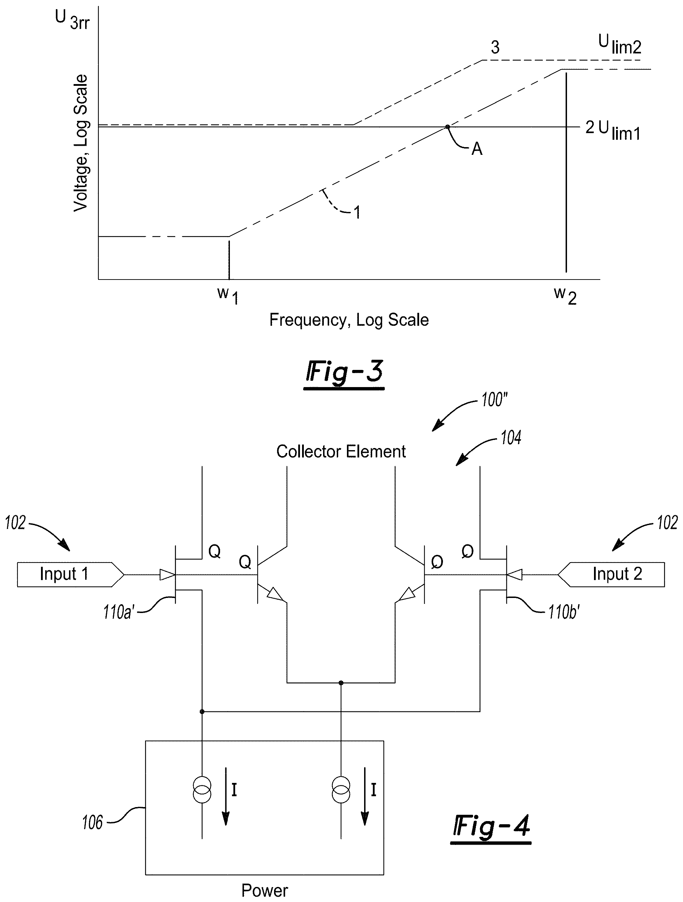

$U_{err}(s)$ increases with the decrease of loop gain, reaching $U_{in}(s)$ at $\beta(s)G(s) = 0$. For a differential stage with bipolar transistors 110a', 110b' (see FIGURE 4 which depicts another example of an amplifier 100"" having bipolar transistors 110a' and 110b')) , the input range of the of the active operation is about 50 mV, for a differential stage with field effect transistors, the input range of the of the active operation is about $2V_p$, where $V_p$ is a transistor pinch-off voltage. This may be correct for the input signal without roll off at high frequencies (with unlimited frequency spectrum).

For the amplifier with a single pole in the transfer function with the frequency $\omega_1$:

$$U_{err}(s) = U_{in}(s) \frac{s + \omega_1}{s + \omega_1(1 + \beta(s)G(s))} = U_{in}(s) \frac{s + \omega_1}{s + \omega_2}$$

where $\omega_2$ - amplifier gain bandwidth product. The plot of this equation is given in FIGURE 3 (see curve 1). In FIGURE 1, the boundary of the active operation of the input stage 102 is depicted as line 2. When the input voltage of the first stage (curve 1) exceeds the limit (line 2) (to the right of point A) distortion is generated. If the boundary of the active operation of the input stage 102 is extended above $U_{err}(s)$, then there will be no intersection point and the input stage 102 may be permanently within active working region. This can be achieved by application of a local current feedback (transconductance reduction) or by proper selection of the active devices (e.g. field effect transistors 110a, 110b). A value for the emitter resistor value for the differential stage with bipolar transistors can be calculated as

$$R_e \geq \frac{2U_{in}}{I_o}$$

where $I_o$ - is a quiescent current of the current source. Under assumption that the bandwidth of input signal is limited by the frequency $\omega_{in}$ and $\omega_{in} < \omega_2$;

$$R_e \geq \frac{2U_{in}}{I_o} \frac{\omega_{in}}{\omega_2}$$

The local degeneration by $R_e$ (emitter resistance) have negative consequences: it considerably decreases the loop gain of the feedback amplifier 100, 100' at low and medium frequencies. The nonlinear distortion, which originated in a power stage (and/or following stages), thus provides a larger contribution in overall distortion. The value for the emitter resistor $R_e$ 108 increases the thermal noise of the amplifier 100, 100'. Low thermal noise for the amplifying stage may be necessary if the input stage 102 operates with a low-impedance signal source.

Local degeneration by $R_e$ can be removed at low and medium frequencies by adding an inductor parallel to the emitter circuit. In that case the differential pair transconductance $g_{m2}$ becomes the function of frequency (see Figure 3, curve 3):

$$g_{m2} = \frac{g_{m1}}{R_e g_{m1} + 1} = \frac{s + 2R_e/L}{s + 2R_e/(2R_e g_{m1} + 1)L}$$

where $g_{m1}$- transconductance of the differential stage without $R_e$

The range of the acceptable input signal is limited by:

$$U_{lim2} = \frac{I_o}{g_{m2}} = U_{lim1}(2R_e g_{m1} + 1)\frac{s + 2R_e/(2R_e g_{m1} + 1)L}{s + 2R_e/L}$$

Where $U_{lim1} = \frac{I_o}{g_{m1}} = 2\varphi_t$ is an acceptable range of the input signal for the differential pair without transconductance reduction. Local degeneration can be removed at low and medium frequencies by the inductor 110. The inductor 110 is susceptible to the unwanted interference from magnetic field.

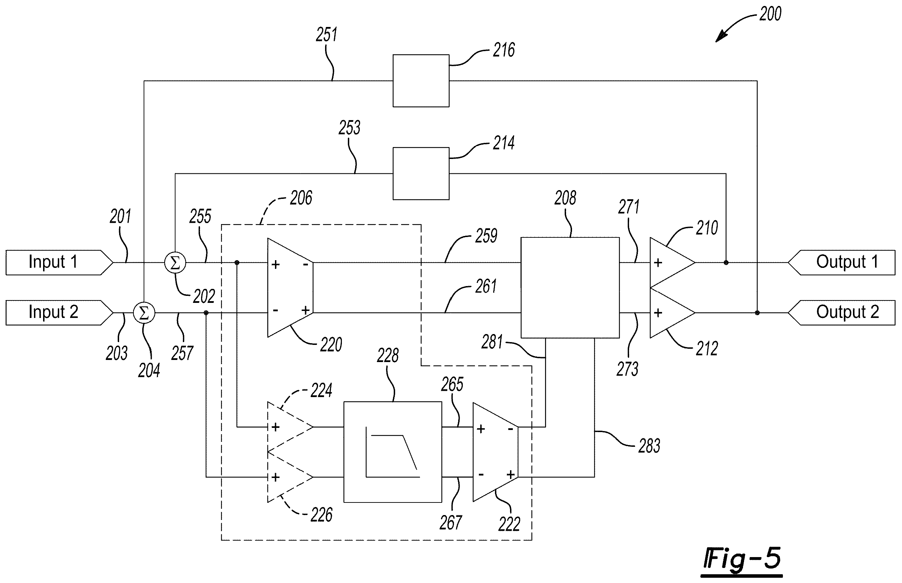

FIGURE 5 depicts a feedback amplifier 200 the ("amplifier 200") in accordance with one embodiment of the present application. The amplifier 200 includes a first summing circuit 202, a second summing circuit 204, an input stage circuit 206, a collector element 208, a first output stage 210, a second output stage 212, a first feedback circuit 214, and a second feedback circuit 216. In general, the first summing circuit 202 receives a first input signal 201 (e.g. on INPUT1 pin) and the second summing circuit 204 receives a second input signal 203 (e.g., on INPUT2 pin). The first feedback circuit 214 and the second feedback circuit 216 each provide a feedback output signal 251, 253 to the first summing circuit 202 and the second summing circuit 204, respectively. The first summing circuit 202 sums the feedback output signal 253 to the first input signal and provides a first input feedback signal 255 to the input stage circuit 206. Similarly, the second summing circuit 202 sums the feedback output signal 251 to the second input signal and provides a second input feedback signal 257 to the input stage circuit 206.

The input stage circuit 206 includes a first gain stage 220, a second gain stage 222, a first buffer circuit 224, a second buffer circuit 226, and a filter (e.g., low pass filter) 228. Each of the first input feedback signal 255 and the second input feedback signal 257 may be wideband signals (e.g., the first input feedback signals 255 and 257 may include both high frequency components and low frequency components). In general, the first input feedback signal 255 and the second input feedback signal 257 may include wideband signals that includes frequency components that are spread out over a broad range (e.g., high and low frequency components) within and above an overall bandwidth of the amplifier 200. For example, the wideband signals may correspond to a frequency that is anywhere from a fraction of a MHz or significantly greater. It is recognized that the wideband signal (e.g., high and low frequency components) provided by the first and the second input signals 201, 203 may dynamically vary, during operation of the amplifier 200, between high and low frequency components and thus the first gain stage 220 may remain operable irrespective of whether high and low frequency components are present on the first and the second input signals 201, 203 (e.g., including the first input feedback signal 255 and the second input feedback signal 257). However, the second gain stage 222 may be operable upon the low frequency components being present on the first and the second input signals 201, 203 (e.g., including the first input feedback signal 255 and the second input feedback signal 257).

The first gain stage 220 may include first and second transistors (not shown) that amplifies the first input feedback signal 255 and the second input feedback signal 257 to provide first and second amplified output signals 259, 261, respectively, whereby each of the first and second amplified output signals 259, 261 are passed to the collector element 208. The collector element 208 combines the first and second amplified output signals 259, 261 to provide double ended to double ended conversion. The collector element 208 generally provides a current or voltage output based on output or load requirements. The collector element 209 may be a current controlled voltage source or a current controlled current source. It is recognized that the first and second amplified output signals 259 and 261 are 180 degrees out of phase from one other. In general, the first gain stage 220 provides the first and second amplified output signals 259 and 261 as amplified difference signals between the first input feedback signal 255 and the second input feedback signal 257 to the collector element 208.

The collector element 208 generates a first output signal 271 and a second output signal 273 and transmits the same to the first output stage 210 and the second output stage 212. The first and second output stages 210, 212 deliver amplified replicas of the first output signals 271, 275 to a load (not shown) thereby providing sufficient output power to output terminals (now shown). In general, the first and second output stages 210, 212 may each provide a final output signal with the required power specification. For example, the first and second output stages 210, 212 condition the output to meet the desired power specification. Each of the first and second output stages 210, 212 may be additional amplifiers that amplify the power of the first output signal 271 and the second output signal 273. If the output load does not require a heavy load, the utilization of the first and second output stages 210, 212 may not be necessary. The first output stage 210 and the second output stage 212 provide the feedback output signals 251, 253 to the first summing circuit 202 and the second summing circuit 204, respectively.

Additionally or alternatively, the first summing circuit 202 and the second summing circuit 204 provide the first input feedback signal 255 and the second input feedback signal 257 to the first buffer circuit 224 and the second buffer circuit 226, respectively, and also passed to the filter 228. The first and second buffer circuits 224, 226 isolate the first and second input feedback signals 255, 257, respectively, to prevent a loading effect from the filter 228. In other words, the first and second buffer circuits 224, 226 may prevent unnecessary or unwanted/undesired loading (e.g., impedance) from the filter 228. The filter 228 may be implemented as one or more low pass filters to low pass filter the first input feedback signal 255 and the second input feedback signal 257 to generate a first and a second filtered feedback signal 265, 267, respectively. With each of the first and the second filtered feedback signals 265, 267 including band limited signals (or low frequency signals or low frequency components). The filter 228 feeds the first and the second filtered feedback signals 265, 267 to the second gain stage 22 with corresponding signals that have a frequency that is below a cutoff frequency as established by the filter 228 while attenuating all frequencies that are above the cutoff frequency to the second gain stage 222. The cut-off frequency for the filter 228 can be adjusted based on a bandwidth of an overall frequency response of the first input signal 201 and the second input signal 203.The second gain stage 222 amplifies the low frequency components to provide first and second gain output signals 281 and 283 to the collector element 208. It is recognized that the first and second amplified output signals 259 and 261 are 180 degrees out of phase from one other. In general, the first gain stage 220 provides the first and second amplified output signals 259 and 261 as difference signals to the collector element 208. The amplification performed by the second gain stage 222 may be effectively defined as a total gain for low frequency components for both the first gain stage 220 and the second gain stage 222. The collector element 208 combines the first amplified output signal 259 with the first gain output signal 281 to generate the first output signal 271 and combines the second amplified output signal 261 with the second gain output signal 283 to generate the second output signal 273. The collector element 208 may couple the current on the first amplified output 250 with current on the first gain output signal 281. Similarly, the collector element 208 may couple the current on the second gain output signal 283 with the current on the second gain output signal 283. It is recognized that the collector element 208 includes active electronics (e.g., diodes, transistors, etc.) and passive electronics (e.g., resistors, capacitors, and inductors, etc.) to fully isolate voltage on the first amplified output signal 259 from voltage on the first gain output signal 281 and to fully isolate voltage on the second amplified output signal 261 from the second gain output signal 283.

The collector element 208 performs one or more of the following: (a) unwanted signal coupling from the first gain stage 220 to the second gain stage 222, (b) interference between the first gain stage 220 and the second gain stage 222, and (c) creates a feedback loop that can cause oscillations or instability in the amplifier 200. The amplification of the high frequency components on the first input feedback signal 255 and the second input feedback signal 257 as may be defined by a transconductance of the first gain stage 222. In general, the parameters (or cutoff frequency) of the filter 228, transconductance of the first gain stage 220 and the second gain stage 222 and corresponding input overload margins may be tailored to the spectrum of the first and second input signal and parameters of the first and second input signals in a time domain. While FIGURE 5 illustrates two

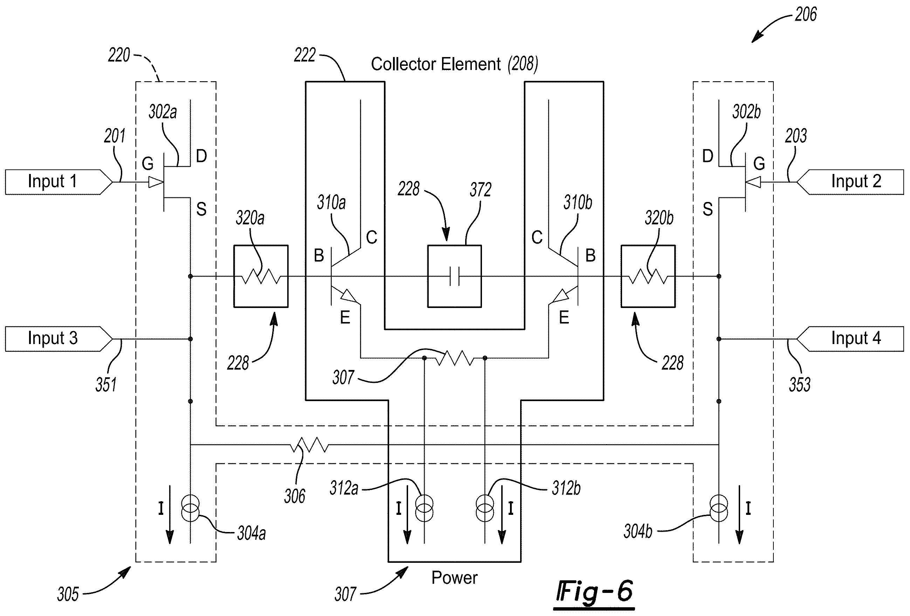

FIGURE 6 depicts a detailed representation of the input stage circuit 206 of the amplifier 200 of FIGURE 1 in accordance with one embodiment. As noted above, the input stage circuit 206 includes the first gain stage 220, the second gain stage 222, and the filter 228. As generally shown in FIGURE 6, the first gain stage 220 includes a first transistor 302a, a second transistor 302b, a first current source 304a, a second current source 304b, and a resistor (or transconductance setting resistor) 306. In one example, the first and second transistors 302a, 302b may be a metal -oxide-semiconductor field-effect transistor (MOSFET). Each of the first and second transistors 302a, 302b includes a pin that corresponds to a gate, drain, and source.

The second gain stage 222 includes a third transistor 310a, a fourth transistor 310b, a third current source 312a, a fourth current source 312b, and a resistor 311. Each of the third transistor 310a and the fourth transistor 310b includes a corresponding pin that corresponds to a base, collector, and emitter. The filter 228 generally includes a first resistor 320a, a second resistor 320b, and a capacitor 322. Bases of the third and fourth transistors 310a, 310b are coupled to sources of the first and second transistors 302a, 302b, via the resistor 320a and the resistor 320b, respectively. In addition, bases of the third and fourth transistors 310a, 310b are coupled to the capacitor 322.

The gate terminal of the first transistor 302a receives the first input feedback signal 255 and the gate terminal of the second transistor 302b receives the second input feedback signal 257. In addition, a source terminal of the first transistor 302a can provide a first current input signal 351 (e.g., INPUT 3) to the input stage circuit 206. The source terminal of the second transistor 302b provides a second current input signal 353 (e.g., INPUT4) to the input stage circuit 206. The first gain stage 220 and the second gain stage 222 provide outputs currents that are combined in the collector element 208. The first, second, third, and fourth current sources 304a, 304b, 312a, 312b are direct current (DC) current sources. The first and second current sources 304a, 304b establish a bias for the first transistor 302a, the second transistor 302b, respectively. The third and fourth current source 312a, 312b establish a bias for the third transistor 310a and the fourth transistor 310b, respectively. The input stage circuit 206 provides output currents (e.g., I) via the drain terminals of the first transistor 302a and the second transistor 302b and via the collector terminals of the third transistor 310a and the fourth transistor 310b. The collector elements 208 collects or combines the currents provided by the first transistor 302a, the second transistor 302b, the third transistor 310a, and the fourth transistor 310b and provides the collected currents to the output stages 210 and 212. In general, the input stage circuit 206 may be used in a dual differential feedback amplifier as shown with the plurality of feedback loops as shown in connection with FIGURE 5.

The current sources 304a and 304b and the resistor 306 of the first gain stage 220 form a first transconductance setting network 305 whereby the current as output therefrom is generally proportional to a voltage drop across the resistor 306. The current sources 312a and 312b and the resistor 307 of the second gain stage 220 form a second transconductance setting 309. In general, the resistor 307 receives current from the emitter of the third transistor 310a and the fourth transistor 310b. Thus, in the regard, the resistor 307 behaves as a transconductance setting resistor to the second gain stage 222. The emitters for both the third transistor 310a and the fourth transistor 310b may be coupled to one another and therefore the value of the resistor 307 is generally equal to zero.

In general, transconductance generally corresponds to what the desired output current is for a certain input voltage. The first and the second gain stages 220, 222 may operate independently from one another or may the first and the second gain stages 220, 222 may operate at the same time. When the first and second gain stages 220, 222 operate that the same time, the stages 220, 222 provide output currents that are combined. The factor that determines whether the first and the second gain stages 220, 222 operated independently or simultaneously is generally based on an incoming frequency that is present on the first and the second input feedback signals 255, 257. For example, in the event the incoming frequency that is present on the first and the second input feedback signals 255 is greater than a first predetermined threshold (or the cutoff frequency established at the filter 228), then the first gain stage 220 only provides the first and second amplified output signals 259, 261. In moments in which the incoming frequency that is present on the first and second input feedback signals 255, 257 is less than or equal to the cutoff frequency established at the filter 228, then both the first gain stage 220 and the second gain stage 22 are operable. For example, in this case the first gain stage 220 generates the first and second input feedback signals 255, 257 and the second gain stage 222 generates the first and second gain output signals 281 and 283.

Thus, at a low frequency (i.e., when frequency on the first and second feedback back signals 255, 257 is less than the cutoff frequency of the filter 228, the first gain stage 220 and the second gain stage 222 operate in parallel. In this case, a total transconductance for the amplifier 200 is the transconductance for the first gain stage 220 and the transconductance for the second gain stage 222. The transconductance for the first gain stage 220 is lower than that of the second gain stage 222. At a high frequency (i.e., when the frequency on the first and second feedback signals 255, 257 is greater than the cutoff frequency of the filter 228, then the first gain stage 220 is only operable. In general, an active input range for the first gain stage 220 is wider than the active input range for the second gain stage 222. The active input range generally corresponds to a range of the input signals in which input devices operate within its linear region, exceeding this range may lead to distortion or other non-linear effects. Typically, the higher the transconductance, the lower the active input range.

In general, the amplifier 200 has two amplifying paths, a first path including the first gain stage 220, the collector element 208, the first output stage 210, and the second output stage 212, and a second path including the first and second buffer circuits 224, 226, the filter 228, the second gain stage 222, the first output stage 210 and the second output stage 212. The first path provides an input to the first gain stage 22a having a low transconductance. High frequencies as provided on the first input feedback signal 255 and the second input feedback signal 257 are passed to the first gain stage 220 only, in this case, an input overload is not present due to a wide active range that is provided by the first gain stage 220. Low frequency components present on the first input feedback signal 255 and the second input feedback signal 257 are passed both to the first gain stage 220 and the second gain stage 222. The second gain stage 222 provides a narrow active input range and a high transconductance. The presence of the filter 228 prevents the second gain stage 222 from overloading since the filter 228 removes high frequency components.

The collector element 208 may be a passive summing network. The collector element 208 may include any one or more of a resistor network, a resistor bridge, a transformer, active amplifying devices and passive components. The collector element 208 generally prevents unwanted coupling between the first and second amplified output signals 259, 261 provided by the first gain stage 220 and the first and second gain output signals 281 and 283.

It recognized that the controllers as disclosed herein may include various microprocessors, integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, such controllers as disclosed utilizes one or more microprocessors to execute a computer-program that is embodied in a non-transitory computer readable medium that is programmed to perform any number of the functions as disclosed. Further, the controller(s) as provided herein includes a housing and the various number of microprocessors, integrated circuits, and memory devices ((e.g., FLASH, random access memory (RAM), read only memory (ROM), electrically programmable read only memory (EPROM), electrically erasable programmable read only memory (EEPROM)) positioned within the housing. The controller(s) as disclosed also include hardware-based inputs and outputs for receiving and transmitting data, respectively from and to other hardware-based devices as discussed herein.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

FURTHER EXAMPLES

Example 1. A feedback amplifier comprising: an input stage circuit configured to receive at least one input feedback signal having wide band frequency components that include high frequency components and low frequency components, the input stage circuit including: a first gain stage configured to amplify the at least one input feedback signal to generate at least one amplified output signal; a filter configured to filter the wide band frequency components on the at least one input feedback signal to generate at least one filtered feedback signal having a first low frequency component; and a second gain stage configured to amplify the at least one filtered feedback signal having the first low frequency component and to provide at least one gain output signal; and a collector element configured to receive the at least one amplified output signal and the at least one output gain signal having the amplified filtered first low frequency component and to provide at least one output signal to at least one output stage.

Example 2. The feedback amplifier of example 1, wherein the input stage circuit includes at least at least one buffer circuit to isolate the at least one input feedback signal.

Example 3. The feedback amplifier of example 2, wherein the at least one buffer circuit isolate the at least one input feedback signal prior to the filter filtering the wide band frequency components on the at least one input feedback signal to prevent a loading effect from occurring at the filter.

Example 4. The feedback amplifier of example 1 or 2, wherein the first gain stage includes: a first transistor configured to amplify a first input feedback signal of the at least one input feedback signal; and a second transistor configured to amplify a second input feedback signal of the at least one input feedback signal.

Example 5. The feedback amplifier of any of examples 1 to 4, wherein the first gain stage includes: a resistor; a first current source, and a second current source, wherein the resistor, the first current source, and the second current source form a first transconductance setting network for the first gain stage.

Example 6. The feedback amplifier of any of examples 1 to 5, wherein the filter includes a first resistor, a second resistor, and a capacitor.

Example 7. The feedback amplifier of example 6, wherein the first resistor of the filter is coupled to a first transistor of the first gain stage.

Example 8. The feedback amplifier of example 7, wherein the second resistor is coupled to a second transistor of the first gain stage.

Example 9. The feedback amplifier of any of examples 1 to 8, wherein the second gain stage includes a first transistor, and a second transistor, and wherein the filter includes a capacitor coupled to the first transistor and the second transistor.

Example 10. A feedback amplifier comprising: an input stage circuit configured to receive at least one input feedback signal having wide band frequency components that include high frequency components and low frequency components, the input stage circuit including: a first gain stage configured to amplify the at least one input feedback signal to generate at least one amplified output signal; a filter configured to filter the wide band frequency components on the at least one input feedback signal to generate at least one filtered feedback signal having a first low frequency component; and a second gain stage configured to amplify the at least one filtered feedback signal having the first low frequency component and to provide at least one gain output signal; a collector element configured to receive the at least one amplified output signal and the at least one output gain signal having the amplified filtered first low frequency component and to generate at least one output signal based on the at the at least one amplified output signal and the at least one output gain signal; and at least one output stage configured to receive the at least one amplified output signal and to amplify the at least one amplified output signal to generate at least one final output signal.

Example 11. The feedback amplifier of example 10, wherein the input stage circuit includes at least at least one buffer circuit to isolate the at least one input feedback signal.

Example 12. The feedback amplifier of example 11, wherein the at least one buffer circuit isolate the at least one input feedback signal prior to the filter filtering the wide band frequency components on the at least one input feedback signal to prevent a loading effect from occurring at the filter.

Example 13. The feedback amplifier of any of examples 10 to 12, wherein the first gain stage includes: a first transistor configured to amplify a first input feedback signal of the at least one input feedback signal; and a second transistor configured to amplify a second input feedback signal of the at least one input feedback signal.

Example 14. The feedback amplifier of any of examples 10 to 13, wherein the first gain stage includes: a resistor; a first current source, and a second current source, wherein the resistor, the first current source, and the second current source form a first transconductance setting network for the first gain stage.

Example 15. The feedback amplifier of any of examples 10 to 14, wherein the filter includes a first resistor, a second resistor, and a capacitor.

Example 16. The feedback amplifier of example 15, wherein the first resistor of the filter is coupled to a first transistor of the first gain stage.

Example 17. The feedback amplifier of example 16, wherein the second resistor is coupled to a second transistor of the first gain stage.

Example 18. The feedback amplifier of any of examples 10 to 17, wherein the second gain stage includes a first transistor, and a second transistor, and wherein the filter includes a capacitor coupled to the first transistor and the second transistor.

Example 19. A feedback amplifier comprising: an input stage circuit configured to receive at least one input feedback signal having high frequency components and low frequency components, the input stage circuit including: a first gain stage configured to amplify the at least one input feedback signal to generate at least one amplified output signal; a filter configured to filter the at least one input feedback signal to generate at least one filtered feedback signal having a first low frequency component; and a second gain stage configured to amplify the at least one filtered feedback signal having the first low frequency component and to provide at least one gain output signal; and a collector element configured to receive the at least one amplified output signal to the at least one output gain signal having the amplified filtered first low frequency component and to provide at least one output signal to at least one output stage.

Example 20. The feedback amplifier of any of examples 10 to 19, wherein the input stage circuit includes at least at least one buffer circuit to isolate the at least one input feedback signal prior to the filter filtering the wide band frequency components on the at least one input feedback signal.

## Claims

1. A feedback amplifier comprising:

    an input stage circuit configured to receive at least one input feedback signal having wide band frequency components that include high frequency components and low frequency components, the input stage circuit including:

        a first gain stage configured to amplify the at least one input feedback signal to generate at least one amplified output signal;
        a filter configured to filter the wide band frequency components on the at least one input feedback signal to generate at least one filtered feedback signal having a first low frequency component; and
        a second gain stage configured to amplify the at least one filtered feedback signal having the first low frequency component and to provide at least one gain output signal; and

    a collector element configured to receive the at least one amplified output signal and the at least one output gain signal having the amplified filtered first low frequency component and to provide at least one output signal to at least one output stage.

2. The feedback amplifier of claim 1, wherein the input stage circuit includes at least at least one buffer circuit to isolate the at least one input feedback signal.

3. The feedback amplifier of claim 2, wherein the at least one buffer circuit isolate the at least one input feedback signal prior to the filter filtering the wide band frequency components on the at least one input feedback signal to prevent a loading effect from occurring at the filter.

4. The feedback amplifier of claim 1, wherein the first gain stage includes:

    a first transistor configured to amplify a first input feedback signal of the at least one input feedback signal; and
    a second transistor configured to amplify a second input feedback signal of the at least one input feedback signal.

5. The feedback amplifier of claim 1, wherein the first gain stage includes:

    a resistor;
    a first current source, and

a second current source,
wherein the resistor, the first current source, and the second current source form a first transconductance setting network for the first gain stage.

6. The feedback amplifier of claim 1, wherein the filter includes a first resistor, a second resistor, and a capacitor.

7. The feedback amplifier of claim 6, wherein the first resistor of the filter is coupled to a first transistor of the first gain stage.

8. The feedback amplifier of claim 7, wherein the second resistor is coupled to a second transistor of the first gain stage.

9. The feedback amplifier of claim 1, wherein the second gain stage includes a first transistor, and a second transistor, and wherein the filter includes a capacitor coupled to the first transistor and the second transistor.

10. The feedback amplifier of claim 1, wherein the at least one output stage is configured to receive the at least one amplified output signal and to amplify the at least one amplified output signal to generate at least one final output signal.

11. The feedback amplifier of claim 10, wherein the input stage circuit includes at least at least one buffer circuit to isolate the at least one input feedback signal.

12. The feedback amplifier of claim 11, wherein the at least one buffer circuit isolate the at least one input feedback signal prior to the filter filtering the wide band frequency components on the at least one input feedback signal to prevent a loading effect from occurring at the filter.

13. The feedback amplifier of claim 10, wherein the first gain stage includes:

a first transistor configured to amplify a first input feedback signal of the at least one input feedback signal; and
a second transistor configured to amplify a second input feedback signal of the at least one input feedback signal.

14. The feedback amplifier of claim 10, wherein the first gain stage includes:

a resistor;
a first current source, and
a second current source,
wherein the resistor, the first current source, and the second current source form a first transconductance setting network for the first gain stage.

15. The feedback amplifier of claim 10, wherein the filter includes a first resistor, a second resistor, and a capacitor; wherein the first resistor of the filter is coupled to a first transistor of the first gain stage; and wherein the second resistor is coupled to a second transistor of the first gain stage.

Collector Element

Input 1

Input 2

Q

Q

110a

110b

R

108

I

I

Power

100

102

104

102

106

<u>*Fig-1*</u>

Collector Element

Input 1

Input 2

Q

Q

110a

110b

107

111

L

R

108

I

I

Power

100'

102

104

102

106

<u>*Fig-2*</u>

*Fig-3*

*Fig-4*

*Fig-5*

EP 4 769 942 A1

*Fig-6*

206

Input 2
203
302b
G
D  S
320b
228
Collector Element (208)
310b
B
C
E
372
228
310a
C
B
E
307
222
320a
228
I
304b
312b
I
312a
306
Power
307
304a
I
220
302a
D  S
G
201
Input 1
351
Input 3
353
Input 4
305

**Europäisches Patentamt**
**European Patent Office**
**Office européen des brevets**

# EUROPEAN SEARCH REPORT

**Application Number**

EP 25 22 7540

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DUY-DONG PHAM ET AL: "Feedforward technique for offset cancellation in broadband differential amplifiers", INTEGRATED CIRCUITS, ISIC '09. PROCEEDINGS OF THE 2009 12TH INTERNATIONAL SYMPOSIUM ON IEEE, PISCATAWAY, NJ, USA, 14 December 2009 (2009-12-14), pages 429-432, XP031622842, ISBN: 9789810824686 * page 429, left-hand column, line 13 - page 431, right-hand column, line 43; figures 1-6 * | 1-15 | INV. H03F1/32 H03F3/45 H03F3/21 |
| A | US 6 150 885 A (ASHBY KIRK BURTON [US] ET AL) 21 November 2000 (2000-11-21) * column 1, line 5 - column 6, line 22; figures 1-10 * | 1-15 | |
| A | US 2004/166824 A1 (FRANCA-NETO LUIZ M [US]) 26 August 2004 (2004-08-26) * paragraphs [0002] - [0019]; figures 1-4 * | 1-15 | |

**TECHNICAL FIELDS SEARCHED (IPC)**

H03F

The present search report has been drawn up for all claims

| Place of search | Date of completion of the search | Examiner |
|---|---|---|
| The Hague | 4 May 2026 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 7540

This annex lists the patent family members relating to the patent documents cited in the above-mentioned European search report.
The members are as contained in the European Patent Office EDP file on
The European Patent Office is in no way liable for these particulars which are merely given for the purpose of information.

04-05-2026

| Patent document cited in search report | | Publication date | Patent family member(s) | | Publication date |
|---|---|---|---|---|---|
| US 6150885 | A | 21-11-2000 | EP | 1063769 A2 | 27-12-2000 |
| | | | JP | 3510183 B2 | 22-03-2004 |
| | | | JP | 2001036381 A | 09-02-2001 |
| | | | KR | 20010007501 A | 26-01-2001 |
| | | | US | 6150885 A | 21-11-2000 |
| US 2004166824 | A1 | 26-08-2004 | US | 6697611 B1 | 24-02-2004 |
| | | | US | 2004166824 A1 | 26-08-2004 |

EPO FORM P0459

For more details about this annex : see Official Journal of the European Patent Office, No. 12/82